# EUROPEAN PATENT APPLICATION

(11) **EP 3 933 425 A1**
(43) Date of publication of application: **05.01.2022**
(21) Application number: 20182851.4
(22) Date of filing: 29.06.2020
(51) Int. Cl.: G01R 33/34, G01R 33/3415, G01R 33/36

(54) **FLEXIBLE MAGNETIC RESONANCE IMAGING RECEIVE ANTENNA**

(71) Applicant: Koninklijke Philips N.V., 5656 AG Eindhoven (NL)
(72) Inventor: SCHMALE, Ingo, 5656 AE Eindhoven (NL); KUHN, Norbert, 5656 AE Eindhoven (NL); LEUSSLER, Christoph, 5656 AE Eindhoven (NL)
(74) Representative: Philips Intellectual Property & Standards

(57) **Abstract**

Disclosed herein is a medical system (100, 400, 500, 600, 700, 800, 900) comprising a magnetic resonance imaging receive antenna (102). The magnetic resonance imaging receive antenna comprises: a flexible substrate (104, 104'), and multiple receive coil elements (106). Each of the multiple receive coil elements comprises a loop antenna (108) configured for independently receiving a magnetic resonance imaging signal. Each of the receive coil elements comprise an amplifier unit comprising a PCB mounted amplifier (120) configured for amplifying the magnetic resonance imaging signal. Each amplifier unit comprises an amplifier housing (110) configured for housing the PCB mounted amplifier. The loop antenna of each of the receive coil elements is mechanically attached to the amplifier unit. The amplifier housing of each of the multiple receive coil elements is attached to the flexible substrate.

## Description

### FIELD OF THE INVENTION

The invention relates to Magnetic Resonance Imaging, in particular to receive coils for magnetic resonance imaging.

### BACKGROUND OF THE INVENTION

A large static magnetic field is used by Magnetic Resonance Imaging (MRI) scanners to align the nuclear spins of atoms as part of the procedure for producing images within the body of a patient. Various quantities or properties of the subject can be measured spatially using MRI. Electric and Magnetic fields are used to manipulate the orientation of atomic spins. In response to these manipulations the spins emit a radio frequency signal referred to herein as a magnetic resonance signal. A magnetic resonance imaging scanner uses a magnetic resonance imaging receive coil to receive the magnetic resonance signals emitted by the atomic spins.

United States patent application publication US20080204021A1 discloses a radio frequency apparatus for at least one of (i) receiving and (ii) exciting a magnetic resonance signal includes an item of clothing. The item of clothing includes one or more layers that are stretchable to comport with differently sized and shaped imaging subjects. A plurality of radio frequency coils are attached to one or more layers of the item of clothing. The coils are relatively movable with respect to one another responsive to stretching of the stretchable item of clothing. The one or more layers of the item of clothing include an antimicrobial agent disposed on or incorporated into at least one layer.

### SUMMARY OF THE INVENTION

The invention provides for a medical system and a method in the independent claims. Embodiments are given in the dependent claims.

A difficulty with incorporating magnetic resonance imaging receive antennas into flexible substrates such as cloths for flexible foams is that receive coil elements which make up magnetic resonance imaging receive antennas tend to reduce the bendability and flexibility of the flexible substrate. Embodiments may provide for a magnetic resonance imaging receive antennas that is more flexible by not attaching the loop antenna to the flexible substrate. The loop antennas are mechanically attached to its amplifier unit. The amplifier unit controls the relative position of the loop antenna but the loop antenna is free to move more than if it had been sewn or attached directly to the flexible substrate.

In one aspect the invention provides for a medical system that comprises a magnetic resonance imaging receive antenna. The magnetic resonance imaging receive antenna comprises a flexible substrate and multiple receive coil elements. Each of the multiple receive coil elements comprises a loop antenna configured for independently receiving a magnetic resonance imaging signal.

Each of the receive coil elements comprises an amplifier unit comprising a printed circuit board mounted amplifier configured for amplifying the magnetic resonance imaging signal. Each amplifier unit comprises an amplifier housing configured for housing the printed circuit board mounted amplifier. The loop antenna of each of the receive coil elements is mechanically attached to the amplifier unit. The amplifier housing of each of the multiple receive coil elements is attached to the flexible substrate.

This embodiment may be beneficial because it may provide for a magnetic resonance imaging receive antenna that is extremely flexible and able to be placed onto the subject. The loop antenna of each of the receive coil elements can be mechanically attached to the amplifier unit in several different ways. In one example the loop antenna is mechanically attached to the printed circuit board mounted amplifier. In another example the loop antenna is mechanically attached to the amplifier housing. In some examples the loop antenna will have a mechanical attachment to both the amplifier housing and the printed circuit board mounted amplifier. In both cases this may provide excellent mechanical attachment while providing for a maximal flexibility of the magnetic resonance imaging receive antenna.

In another embodiment the flexible substrate is a fabric substrate. The fabric substrate may for example be a woven or non-woven substrate. In some examples the fabric substrate may take the form of a blanket. The use of a fabric substrate may be beneficial because it may provide for an extremely flexible magnetic resonance imaging receive antenna as well as providing for comfort and warmth for the subject during the examination. In another embodiment the loop antenna is mechanically positioned by the amplifier housing. The loop antenna is free hanging. By free hanging this means that the only mechanical attachments the loop antenna has are to the amplifier housing. Having the loop antenna be free hanging enables the loop antenna to bend more freely. This may provide for a magnetic resonance imaging receive antenna with a greater degree of flexibility.

In another embodiment the amplifier housing comprises a mounting surface contacting the flexible substrate. The mounting surface comprises multiple holes. The amplifier housing is attached to the flexible substrate by multiple thread strands passing through the multiple holes and the flexible substrate. This embodiment may be beneficial because it may provide for an extremely durable and long-lasting means of attaching the amplifier housing to the flexible substrate. This embodiment may be described alternatively as sewing the amplifier housing to the flexible substrate by passing strands of thread through the multiple holes. Another advantage would be that if the threads become worn or if the amplifier housing begins to detach the magnetic resonance imaging receive antenna can be easily repaired by re-sewing the amplifier housing to the flexible substrate.

In another embodiment the magnetic resonance imaging receive antenna comprises a fabric cover. The amplifier housing further comprises a second mounting surface that comprises second multiple holes. The amplifier housing is attached to the second flexible substrate by second multiple thread strands passing through second multiple holes and the fabric cover. In this embodiment there are essentially two fabric pieces that cover both sides of the multiple receive coil elements. The attachments in both cases are to the amplifier housings. This may provide for a magnetic resonance imaging receive antenna that is completely covered but yet is extremely flexible. If the loop antennas were sewn to the flexible substrate or to the fabric cover then it may result in making the magnetic resonance imaging antenna too rigid.

In another embodiment the flexible substrate is a flexible foam. The elastomeric foam comprises an array of amplifier housing unit receptacles configured for receiving the amplifier housing of each receive coil element. Each amplifier housing is attached to one of the amplifier housing unit receptacles. In this example the flexible substrate could be a piece of planar foam that has depressions or cut-outs that form the amplifier housing unit receptacles. This embodiment may be beneficial because it provides for a means of having a flexible magnetic resonance imaging receive antenna as well as partially padding the amplifier housings.

In another embodiment the loop antenna of each receive coil element is mechanically positioned by the amplifier unit. The loop antenna of each receive coil element is free hanging. In this example when the flexible substrate is a flexible foam, the loop antennas are free hanging also. This may provide for a greater degree of flexibility.

In another embodiment the flexible foam comprises a loop antenna groove configured for receiving and mechanically positioning the loop antenna of the amplifier unit. This embodiment may be beneficial because it provides for a magnetic resonance imaging receive antenna that is smoother. It also has the loop antennas protected by the flexible foam.

In another embodiment the multiple receive coil elements are encapsulated between the flexible foam and the flexible sheet. This may be beneficial because all of the components of the magnetic resonance imaging receive antenna are encapsulated. This may for example help to keep the subject away or from touching the loop antennas.

In another embodiment the flexible sheet is a fabric.

In another embodiment at least 50% of the amplifier housing is encircled by the loop antenna. In another example at least 90% of the amplifier housing is encircled by the loop antenna. This may be beneficial because it reduces the overall footprint or size of the multiple receive coil elements. This may provide for greater flexibility of the magnetic resonance imaging receive antenna. By encircled, this means that the amplifier housing is positioned within an area or volume which is surrounded by the loop antenna.

In another embodiment the amplifier housing is at least partially encircled by the loop antenna of an adjacent amplifier circuit. For example, the amplifier circuits may have their loop antennas partially overlapping. In this embodiment this means that the amplifier housing is within a space that is encircled at least partially by two loop antennas. This again may also provide for greater mechanical flexibility of the magnetic resonance imaging receive antenna.

In another embodiment the medical system further comprises a magnetic resonance imaging system configured for acquiring k-space data from an imaging zone using the magnetic resonance imaging receive antenna. In nuclear magnetic resonance or magnetic resonance imaging radio-frequency fields and magnetic fields are used to manipulate the orientation of atomic spins. As they relax to their original or thermal position, they emit radio-frequency signals which are referred to herein as a magnetic resonance imaging signal. The recorded magnetic resonance imaging signals that are acquired according to a magnetic resonance imaging protocol are referred to herein as k-space data. The k-space data can be reconstructed into image space to reconstruct a magnetic resonance image. This embodiment may be beneficial because the integration of the magnetic resonance imaging receive antenna with the magnetic resonance imaging system may provide for a magnetic resonance imaging system that has a more flexible and possibly more comfortable surface coil to use with a subj ect.

In another embodiment the medical system further comprises a memory containing machine-executable instructions and pulse sequence commands. The medical system further comprises a computational system configured for controlling the medical system. Execution of the machine-executable instructions causes the computational system to computational system to acquire the k-space data with the magnetic resonance imaging receive antenna by controlling the magnetic resonance imaging system with the pulse sequence commands. Execution of the machine-executable instructions further causes the computational system to reconstruct magnetic resonance imaging data from the k-space data. For example, the magnetic resonance imaging data may be two-dimensional slices or images or it may be a three-dimensional dataset. In either case the magnetic resonance imaging data may be rendered or displayed using a display or other graphics interface.

It is understood that one or more of the aforementioned embodiments of the invention may be combined as long as the combined embodiments are not mutually exclusive.

As will be appreciated by one skilled in the art, aspects of the present invention may be embodied as an apparatus, method or computer program product. Accordingly, aspects of the present invention may take the form of an entirely hardware embodiment, an entirely software embodiment (including firmware, resident software, microcode, etc.) or an embodiment combining software and hardware aspects that may all generally be referred to herein as a "circuit," "module" or "system." Furthermore, aspects of the present invention may take the form of a computer program product embodied in one or more computer readable medium(s) having computer executable code embodied thereon.

Any combination of one or more computer readable medium(s) may be utilized. The computer readable medium may be a computer readable signal medium or a computer readable storage medium. A 'computer-readable storage medium' as used herein encompasses any tangible storage medium which may store instructions which are executable by a processor or computational system of a computing device. The computer-readable storage medium may be referred to as a computer-readable non-transitory storage medium. The computer-readable storage medium may also be referred to as a tangible computer readable medium. In some embodiments, a computer-readable storage medium may also be able to store data which is able to be accessed by the computational system of the computing device. Examples of computer-readable storage media include, but are not limited to: a floppy disk, a magnetic hard disk drive, a solid state hard disk, flash memory, a USB thumb drive, Random Access Memory (RAM), Read Only Memory (ROM), an optical disk, a magneto-optical disk, and the register file of the computational system. Examples of optical disks include Compact Disks (CD) and Digital Versatile Disks (DVD), for example CD-ROM, CD-RW, CD-R, DVD-ROM, DVD-RW, or DVD-R disks. The term computer readable-storage medium also refers to various types of recording media capable of being accessed by the computer device via a network or communication link. For example, data may be retrieved over a modem, over the internet, or over a local area network. Computer executable code embodied on a computer readable medium may be transmitted using any appropriate medium, including but not limited to wireless, wire line, optical fiber cable, RF, etc., or any suitable combination of the foregoing.

A computer readable signal medium may include a propagated data signal with computer executable code embodied therein, for example, in baseband or as part of a carrier wave. Such a propagated signal may take any of a variety of forms, including, but not limited to, electro-magnetic, optical, or any suitable combination thereof. A computer readable signal medium may be any computer readable medium that is not a computer readable storage medium and that can communicate, propagate, or transport a program for use by or in connection with an instruction execution system, apparatus, or device.

'Computer memory' or 'memory' is an example of a computer-readable storage medium. Computer memory is any memory which is directly accessible to a computational system. 'Computer storage' or 'storage' is a further example of a computer-readable storage medium. Computer storage is any non-volatile computer-readable storage medium. In some embodiments computer storage may also be computer memory or vice versa.

A 'computational system' as used herein encompasses an electronic component which is able to execute a program or machine executable instruction or computer executable code. References to the computational system comprising the example of "a computational system" should be interpreted as possibly containing more than one computational system or processing core. The computational system may for instance be a multi-core processor. A computational system may also refer to a collection of computational systems within a single computer system or distributed amongst multiple computer systems. The term computational system should also be interpreted to possibly refer to a collection or network of computing devices each comprising a processor or computational systems. The machine executable code or instructions may be executed by multiple computational systems or processors that may be within the same computing device or which may even be distributed across multiple computing devices.

Machine executable instructions or computer executable code may comprise instructions or a program which causes a processor or other computational system to perform an aspect of the present invention. Computer executable code for carrying out operations for aspects of the present invention may be written in any combination of one or more programming languages, including an object oriented programming language such as Java, Smalltalk, C++ or the like and conventional procedural programming languages, such as the "C" programming language or similar programming languages and compiled into machine executable instructions. In some instances, the computer executable code may be in the form of a high-level language or in a pre-compiled form and be used in conjunction with an interpreter which generates the machine executable instructions on the fly. In other instances, the machine executable instructions or computer executable code may be in the form of programming for programmable logic gate arrays.

The computer executable code may execute entirely on the user's computer, partly on the user's computer, as a stand-alone software package, partly on the user's computer and partly on a remote computer or entirely on the remote computer or server. In the latter scenario, the remote computer may be connected to the user's computer through any type of network, including a local area network (LAN) or a wide area network (WAN), or the connection may be made to an external computer (for example, through the Internet using an Internet Service Provider).

Aspects of the present invention are described with reference to flowchart illustrations and/or block diagrams of methods, apparatus (systems) and computer program products according to embodiments of the invention. It is understood that each block or a portion of the blocks of the flowchart, illustrations, and/or block diagrams, can be implemented by computer program instructions in form of computer executable code when applicable. It is further under stood that, when not mutually exclusive, combinations of blocks in different flowcharts, illustrations, and/or block diagrams may be combined. These computer program instructions may be provided to a computational system of a general purpose computer, special purpose computer, or other programmable data processing apparatus to produce a machine, such that the instructions, which execute via the computational system of the computer or other programmable data processing apparatus, create means for implementing the functions/acts specified in the flowchart and/or block diagram block or blocks.

These machine executable instructions or computer program instructions may also be stored in a computer readable medium that can direct a computer, other programmable data processing apparatus, or other devices to function in a particular manner, such that the instructions stored in the computer readable medium produce an article of manufacture including instructions which implement the function/act specified in the flowchart and/or block diagram block or blocks.

The machine executable instructions or computer program instructions may also be loaded onto a computer, other programmable data processing apparatus, or other devices to cause a series of operational steps to be performed on the computer, other programmable apparatus or other devices to produce a computer implemented process such that the instructions which execute on the computer or other programmable apparatus provide processes for implementing the functions/acts specified in the flowchart and/or block diagram block or blocks.
A 'user interface' as used herein is an interface which allows a user or operator to interact with a computer or computer system. A 'user interface' may also be referred to as a 'human interface device.' A user interface may provide information or data to the operator and/or receive information or data from the operator. A user interface may enable input from an operator to be received by the computer and may provide output to the user from the computer. In other words, the user interface may allow an operator to control or manipulate a computer and the interface may allow the computer indicate the effects of the operator's control or manipulation. The display of data or information on a display or a graphical user interface is an example of providing information to an operator. The receiving of data through a keyboard, mouse, trackball, touchpad, pointing stick, graphics tablet, joystick, gamepad, webcam, headset, pedals, wired glove, remote control, and accelerometer are all examples of user interface components which enable the receiving of information or data from an operator.
A 'hardware interface' as used herein encompasses an interface which enables the computational system of a computer system to interact with and/or control an external computing device and/or apparatus. A hardware interface may allow a computational system to send control signals or instructions to an external computing device and/or apparatus. A hardware interface may also enable a computational system to exchange data with an external computing device and/or apparatus. Examples of a hardware interface include, but are not limited to: a universal serial bus, IEEE 1394 port, parallel port, IEEE 1284 port, serial port, RS-232 port, IEEE-488 port, Bluetooth connection, Wireless local area network connection, TCP/IP connection, Ethernet connection, control voltage interface, MIDI interface, analog input interface, and digital input interface.

A 'display' or 'display device' as used herein encompasses an output device or a user interface adapted for displaying images or data. A display may output visual, audio, and or tactile data. Examples of a display include, but are not limited to: a computer monitor, a television screen, a touch screen, tactile electronic display, Braille screen, Cathode ray tube (CRT), Storage tube, Bi-stable display, Electronic paper, Vector display, Flat panel display, Vacuum fluorescent display (VF), Light-emitting diode (LED) displays, Electroluminescent display (ELD), Plasma display panels (PDP), Liquid crystal display (LCD), Organic light-emitting diode displays (OLED), a projector, and Head-mounted display.

K-space data is defined herein as being the recorded measurements of radio frequency signals emitted by atomic spins using the antenna of a Magnetic resonance apparatus during a magnetic resonance imaging scan. Magnetic resonance data is an example of tomographic medical image data.

A Magnetic Resonance Imaging (MRI) image, MR image, or magnetic resonance imaging data is defined herein as being the reconstructed two- or three-dimensional visualization of anatomic data contained within the magnetic resonance imaging data. This visualization can be performed using a computer.

### BRIEF DESCRIPTION OF THE DRAWINGS

In the following preferred embodiments of the invention will be described, by way of example only, and with reference to the drawings in which:
Fig. 1 illustrates an example of a magnetic resonance imaging receive antenna;
Fig. 2 shows a further view of the magnetic resonance imaging receive antenna of Fig. 1;
Fig. 3 shows a cross sectional view of the magnetic resonance imaging receive antenna of Fig. 1;
Fig. 4 illustrates a further example of a magnetic resonance imaging receive antenna;
Fig. 5 illustrates a further example of a magnetic resonance imaging receive antenna;
Fig. 6 illustrates a further example of a magnetic resonance imaging receive antenna;
Fig. 7 illustrates a further example of a magnetic resonance imaging receive antenna;
Fig. 8 illustrates a further example of a magnetic resonance imaging receive antenna;
Fig. 9 illustrates an example of a medical system; and
Fig. 10 shows a flow chart which illustrates a method of operating the medical system of Fig. 9.

### DETAILED DESCRIPTION OF THE EMBODIMENTS

Like numbered elements in these figures are either equivalent elements or perform the same function. Elements which have been discussed previously will not necessarily be discussed in later figures if the function is equivalent.

Magnetic Resonance (MR) receive coils may contain 2-dimensional arrays of receive elements, each consisting of a receive loop and an amplifier low-noise amplifier (LNA). The latter is made up from many electronic components that are mounted on a printed circuit board (PCB). In order for the structure to be light-weight and flexible, the receive elements may be attached to flexible cloth.

The state of the art is to sew the loop antenna to the cloth, whilst leaving the PCBs loose. The attachment of the elongated structures, such as the loop, to the cloth strongly reduces flexibility.

MR imaging receive coils with even higher flexibility can be obtained by attaching the PCBs or amplifier housing to a flexible substrate such as cloth, whilst leaving the loop antenna loose. This is the inverse of what has previously been done: now the small element (the amplifier) is attached, whilst the long one (the loop antenna) is loose.

The attachment of the PCB amplifier or its housing to the flexible substrate or cloth can be realized in various forms, such as gluing and sewing. Sewing provides for an attachment with high durability and a long-life.

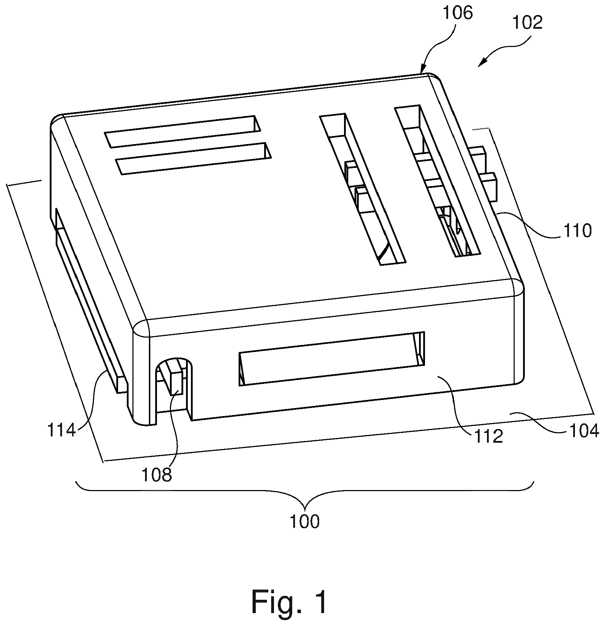

Fig. 1: LNA with housing, consisting of top part and bottom part, protecting the PCB.

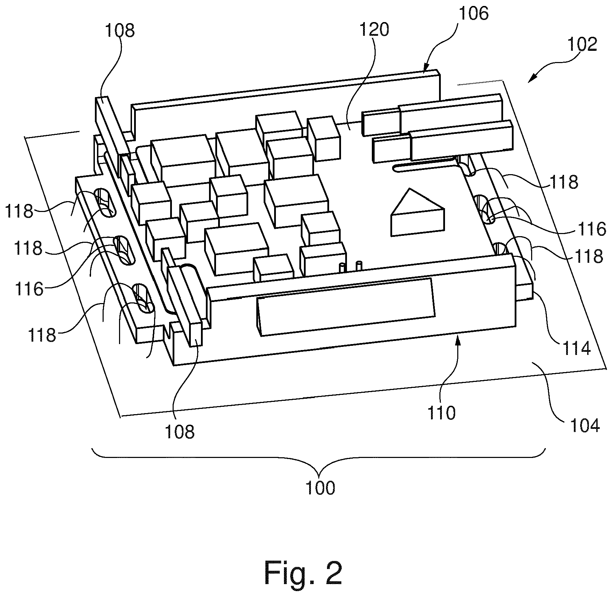

Figs. 1 and 2 illustrate one example of a medical system 100. The medical system 100 comprises a magnetic resonance imaging receive antenna 102. The magnetic resonance imaging receive antenna 102 comprises a flexible substrate 104 and multiple receive coil elements 106. In this example only one receive coil element 106 is depicted. The receive coil element 106 comprises a loop antenna 108. The entire loop antenna 108 is not shown. The receive coil element 106 is shown as further comprising an amplifier housing 110 that comprises a cover 112 that mounts onto a mounting surface 114. The mounting surface 114 has holes 116 with thread strands 118 that sew the mounting surface 114 to the flexible substrate 104. On top of the mounting surface 114 is a PCB or printed circuit board mounted amplifier 120.

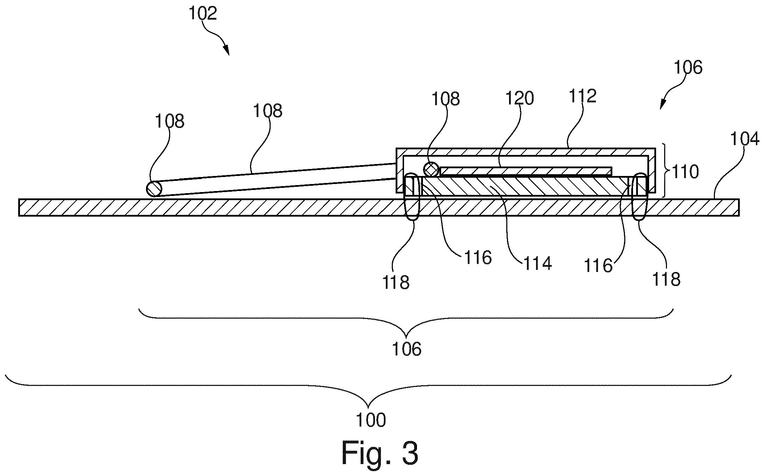

Fig. 3 shows a cross-sectional view of the medical system 100 depicted in Figs. 1 and 2. In this example a single magnetic resonance imaging receive coil element 106 is shown. The loop antenna 108 is shown as being free hanging. It is only attached to the receive coil element 106, this would be the amplifier housing 110 and/or the PCB mounted amplifier 120. As the flexible substrate 104 bends the loop antenna 108 is free to flex and move in position but is held in roughly the same position by being mounted or attached to the receive coil element 106. The flexible substrate 104 could for example be a blanket or other fabric.

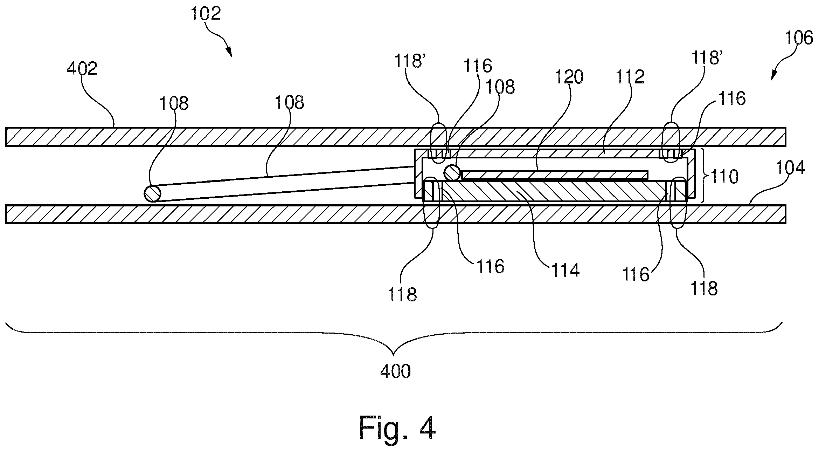

Fig. 4 illustrates a further example of a medical system 400. The medical system 400 is similar to the medical system 100 depicted in Figs. 1-3 except it additionally comprises a fabric cover 402 that is sewn with second thread strands 118' through second holes 116' in the cover 112. The example in Fig. 4 could be considered to be two blankets 402 and 104 that are sewn or attached to the amplifier housing 110. The loop antenna 108 is still free hanging. This means that the magnetic resonance imaging receive antenna 102 would be extremely flexible.

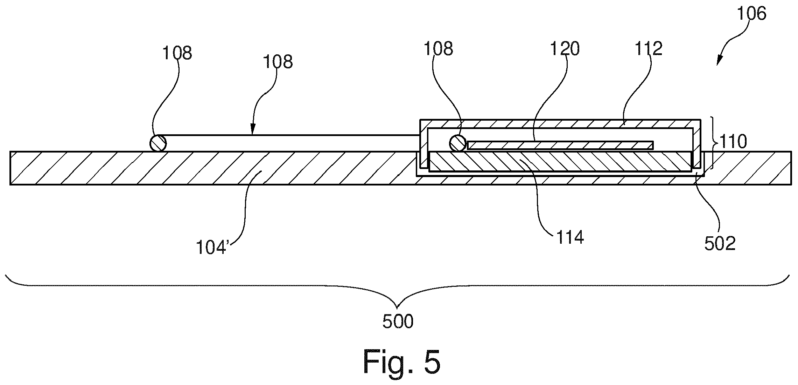

Fig. 5 illustrates a further example of a medical system 500. The medical system is similar to the medical system illustrated in Figs. 1-3 with several mechanical changes. In this case the flexible substrate 104 has been replaced with a flexible foam 104'. Within the flexible foam 104' there is an amplifier housing receptacle 502 for receiving the amplifier housing 110. The amplifier housing 110 could for example be glued or otherwise fixed within the amplifier housing receptacle 502. The loop antenna 108 in this example is still free floating and is shown as resting on the surface of the flexible foam 104'.

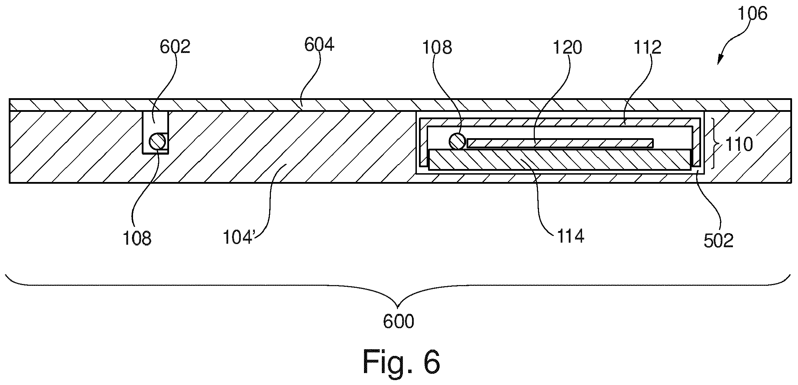

Fig. 6 illustrates a further example of the medical system 600. The example in Fig. 6 is similar to the example illustrated in Fig. 5 except in this case the flexible foam 104' is much thicker. The amplifier housing 110 fits completely within the amplifier housing receptacle 502. Additionally, there is a loop antenna groove 602 cut into the flexible foam 104' to hold the loop antenna 108. Additionally, there is a flexible sheet 604 which is used to seal and encapsulate the entire receive coil element 106 between the flexible sheet 604 and the flexible foam 104'.

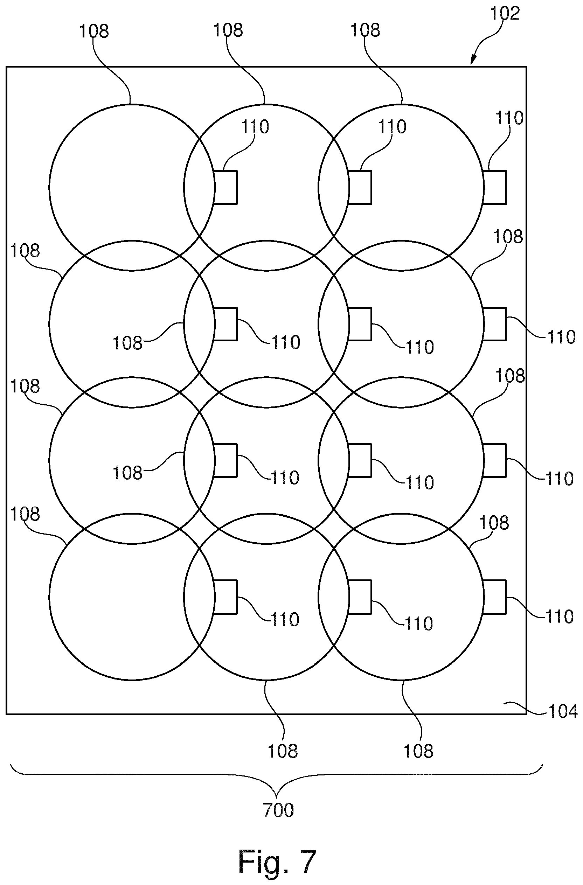

Fig. 7 illustrates a further example of a medical system 700. The medical system is shown as comprising a magnetic resonance imaging receive antenna 102. In this configuration the magnetic resonance imaging receive antenna 102 could be a surface coil that is mounted either to the flexible substrate 104 or the flexible foam 104' as is illustrated in any of Figs. 1-6. In this example the amplifier housing 110 is shown as being encircled by a neighboring loop antenna 108 of a neighboring receive coil element. The loop antennas 108 are able to overlap partially without having a large degree of coupling between the various receive coil elements 106.

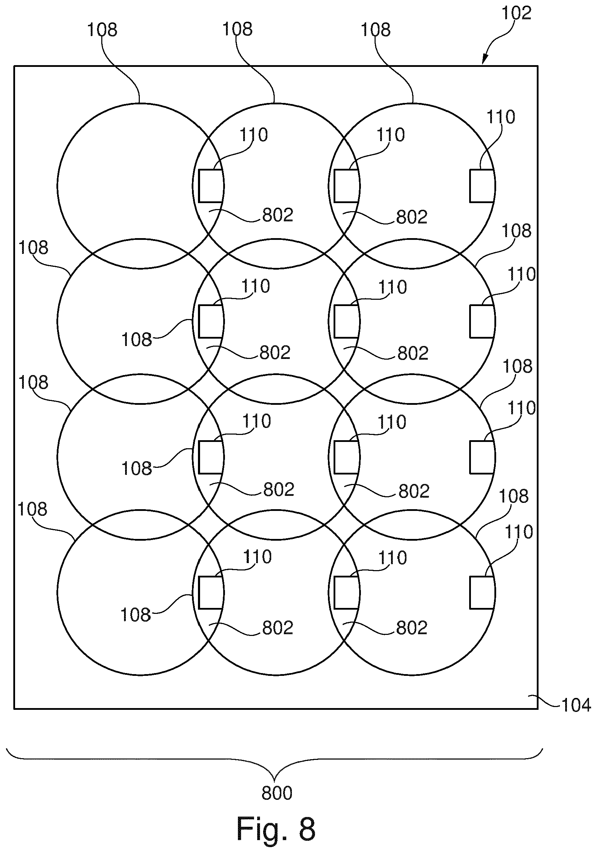

Fig. 8 illustrates a further example of a medical system 800. The arrangement in Fig. 8 is very similar to the arrangement illustrated in Fig. 7 except in this case the amplifier housing 110 is encircled mostly by its own loop antenna 108 as well as a loop antenna of a neighboring receive coil element 106. The amplifier housings 110 are located within the eye-shaped region 802 between two overlapping loop antennas 108. The arrangement shown in Fig. 8 may be advantageous because the positioning of the amplifier housing 110 may enable the magnetic resonance imaging receive antenna 102 to be more flexible and bendable.

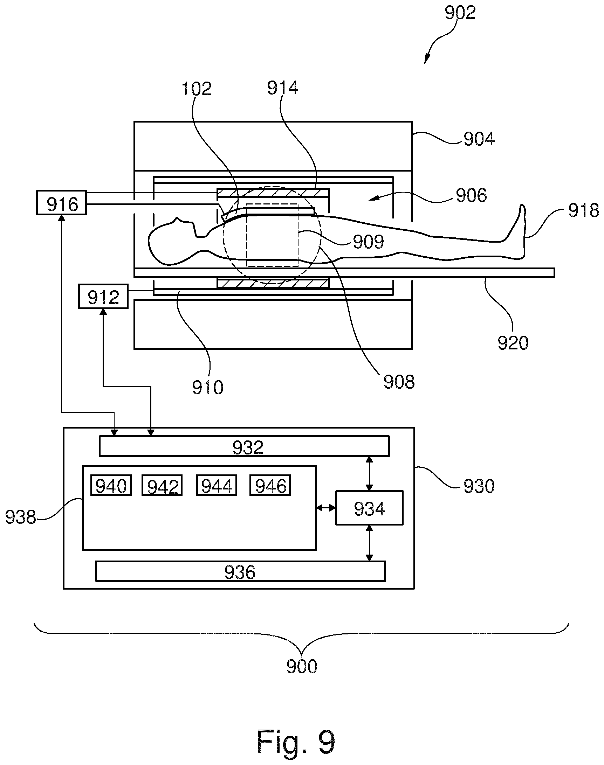

Fig. 9 illustrates a further example of a medical system 900. The medical system 900 in Fig. 9 is shown as comprising additionally a magnetic resonance imaging system 902.

The magnetic resonance imaging system 902 comprises a magnet 904. The magnet 904 is a superconducting cylindrical type magnet with a bore 906 through it. The use of different types of magnets is also possible; for instance it is also possible to use both a split cylindrical magnet and a so called open magnet. A split cylindrical magnet is similar to a standard cylindrical magnet, except that the cryostat has been split into two sections to allow access to the iso-plane of the magnet, such magnets may for instance be used in conjunction with charged particle beam therapy. An open magnet has two magnet sections, one above the other with a space in-between that is large enough to receive a subject: the arrangement of the two sections area similar to that of a Helmholtz coil. Open magnets are popular, because the subject is less confined. Inside the cryostat of the cylindrical magnet there is a collection of superconducting coils.

Within the bore 906 of the cylindrical magnet 904 there is an imaging zone 908 where the magnetic field is strong and uniform enough to perform magnetic resonance imaging. A region of interest 909 is shown within the imaging zone 908. The magnetic resonance data that is acquired typically acquried for the region of interest. A subject 918 is shown as being supported by a subject support 920 such that at least a portion of the subject 918 is within the imaging zone 908 and the region of interest 909.

Within the bore 906 of the magnet there is also a set of magnetic field gradient coils 910 which is used for acquisition of preliminary magnetic resonance data to spatially encode magnetic spins within the imaging zone 908 of the magnet 904. The magnetic field gradient coils 910 connected to a magnetic field gradient coil power supply 912. The magnetic field gradient coils 910 are intended to be representative. Typically magnetic field gradient coils 910 contain three separate sets of coils for spatially encoding in three orthogonal spatial directions. A magnetic field gradient power supply supplies current to the magnetic field gradient coils. The current supplied to the magnetic field gradient coils 910 is controlled as a function of time and may be ramped or pulsed.

The magnetic resonance imaging system 902 is shown as comprising a magnetic resonance imaging receive antenna 102 as is illustrated in any of Figs. 1-8. The magnetic resonance imaging receive antenna 102 is shown as being connected to the transceiver 916. There is also shown an additional transmit coil 914. The transmit coil 914 could for example be a birdcage type coil.

The medical system 900 is further shown as comprising a computer system 930. The computer system 930 comprises a hardware interface 932 that is connected to the transceiver 916 and the magnetic field gradient coil power supply 912. The computer 930 is further shown as containing a computational system 934. The computational system 934 is intended to represent multiple computing cores possibly at various locations. The computational system 934 is shown as being additionally connected to an optional user interface 936 and a memory 938.

The memory 938 is shown as containing pulse sequence commands 940. The pulse sequence commands 940 are instructions or data which may be converted into instructions which can be used to control the operation of the magnetic resonance imaging system 902 to acquire k-space data. The memory 938 is further shown as containing k-space data 942 that has been acquired by controlling the magnetic resonance imaging system 902 with the pulse sequence commands 940. The memory 938 is further shown as containing magnetic resonance imaging data 944 that has been reconstructed into image space from the k-space data 942. The memory 938 is further shown as containing machine executable instructions. The machine executable instructions 946 enable the computational system 934 to control the operation and function of the medical system 900 as well as perform computational and image processing tasks.

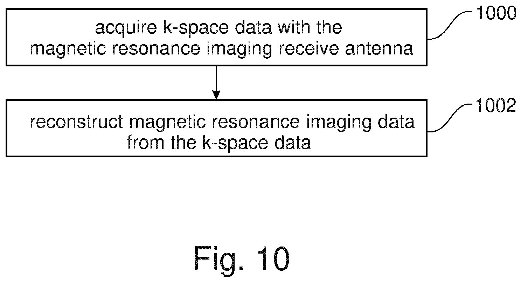

Fig. 10 shows a flowchart which illustrates a method of operating the medical system 900 of Fig. 9. First, in step 1000, the k-space data 942 is acquired by controlling the magnetic resonance imaging system 902 with the pulse sequence commands 940. The k-space data 942 was acquired using the magnetic resonance imaging receive antenna 102. Next, in step 1002, the magnetic resonance imaging data 944 is reconstructed from the k-space data 942. The magnetic resonance imaging data 944 could for example be rendered using a display or stored for later use or retrieval.

While the invention has been illustrated and described in detail in the drawings and foregoing description, such illustration and description are to be considered illustrative or exemplary and not restrictive; the invention is not limited to the disclosed embodiments.

Other variations to the disclosed embodiments can be understood and effected by those skilled in the art in practicing the claimed invention, from a study of the drawings, the disclosure, and the appended claims. In the claims, the word "comprising" does not exclude other elements or steps, and the indefinite article "a" or "an" does not exclude a plurality. A single processor or other unit may fulfill the functions of several items recited in the claims. The mere fact that certain measures are recited in mutually different dependent claims does not indicate that a combination of these measured cannot be used to advantage. A computer program may be stored/distributed on a suitable medium, such as an optical storage medium or a solid-state medium supplied together with or as part of other hardware, but may also be distributed in other forms, such as via the Internet or other wired or wireless telecommunication systems. Any reference signs in the claims should not be construed as limiting the scope.

### LIST OF REFERENCE NUMERALS

- 100: medical system
- 102: magnetic resonance imaging receive antenna
- 104: flexible substrate
- 104': flexible foam
- 106: receive coil element
- 108: loop antenna
- 110: amplifier housing
- 112: cover
- 114: mounting surface
- 116: holes
- 116': second holes
- 118: thread strands
- 118': second thread strands
- 120: PCB mounted amplifier
- 400: medical system
- 402: fabric cover
- 500: medical system
- 502: amplifier housing receptacle
- 600: medical system
- 602: loop antenna groove
- 604: flexible sheet
- 700: medical system
- 800: medical system
- 802: eye shaped region
- 900: medical system
- 902: magnetic resonance imaging system
- 904: magnet
- 906: bore of magnet
- 908: imaging zone
- 909: region of interest
- 910: magnetic field gradient coils
- 912: magnetic field gradient coil power supply
- 914: transmit coil
- 916: transceiver
- 918: subject
- 920: subject support
- 930: computer
- 932: hardware interface
- 934: computational system
- 936: user interface
- 938: memory
- 940: pulse sequene commands
- 942: k-space data
- 944: magentic resonane imaging data
- 946: machine executable instructions
- 1000: acquire k-space data with the magnetic resonance imaging receive antenna by controlling the magnetic resonance imaging system with the pulse sequence commands
- 1002: reconstruct (1002) magnetic resonance imaging data from the k-space data

## Claims

1. A medical system (100, 400, 500, 600, 700, 800, 900) comprising a magnetic resonance imaging receive antenna (102), wherein the magnetic resonance imaging receive antenna comprises:
- a flexible substrate (104, 104'); and
- multiple receive coil elements (106), wherein each of the multiple receive coil elements comprises a loop antenna (108) configured for independently receiving a magnetic resonance imaging signal, wherein each of the receive coil elements comprise an amplifier unit comprising a PCB mounted amplifier (120) configured for amplifying the magnetic resonance imaging signal, wherein each amplifier unit comprises an amplifier housing (110) configured for housing the PCB mounted amplifier, wherein the loop antenna of each of the receive coil elements is mechanically attached to the amplifier unit, wherein the amplifier housing of each of the multiple receive coil elements is attached to the flexible substrate.

2. The medical system of claim 1, wherein the flexible substrate is a fabric substrate (104).

3. The medical system of claim 1 or 2, wherein the loop antenna is mechanically positioned by the amplifier housing, and wherein the loop antenna is free hanging.

4. The medical system of claim 2 or 3, wherein the amplifier housing comprises a mounting surface (114) contacting the flexible substrate, wherein the mounting surface comprises multiple holes (116), wherein the amplifier housing is attached to the flexible substrate by multiple thread strands (118) passing through the multiple holes and the flexible substrate.

5. The medical system of claim 2, 3, or 4 wherein the magnetic resonance imaging receive antenna further comprises a fabric cover (402), wherein the amplifier housing further comprises a second mounting surface that comprises second multiple holes (116'), wherein the amplifier housing is attached to the second flexible substrate by second multiple thread strands (118') passing through the second multiple holes and the fabric cover.

6. The medical system of claim 1, wherein the flexible substrate is a flexible foam (114'), wherein the elastomeric foam comprises an array of amplifier housing unit receptacles (502) configured for receiving the amplifier housing of each receive coil element, wherein each amplifier housing is attached to one of the amplifier housing unit receptacles.

7. The medical system of claim 6, wherein the loop antenna of each receive coil element is mechanically positioned by the amplifier unit, wherein the loop antenna of each receive coil is free hanging.

8. The medical system of claim 6, wherein the flexible foam comprises a loop antenna groove (602) configured for receiving and mechanically positioning the loop antenna of the amplifier unit.

9. The medical system of claim 8, wherein the multiple receive coil elements are encapsulated between the flexible foam and a flexible sheet (604).

10. The medical system of claim 9, wherein the flexible sheet is a fabric.

11. The medical system of any one of the preceding claims, wherein at least 50% of the amplifier housing is encircled by the loop antenna, preferably at least 90% of the amplifier housing is encircled by the loop antenna.

12. The medical system of any one of the preceding claims, wherein the amplifier housing is at least partially encircled by the loop antenna of an adjacent amplifier circuit.

13. The medical system of any one of the preceding claims, wherein the medical system further comprises a magnetic resonance imaging system (902) configured for acquiring k-space data (942) from an imaging zone (508) using the magnetic resonance imaging receive antenna.

14. The medical system of claim 13, wherein the medical system further comprises a memory (938) containing machine executable instructions (946) and pulse sequence commands (940), wherein the medical system further comprises a computational system (934) configured for controlling the medical system, wherein execution of the machine executable instructions causes the computational system to:
- acquire (1000) the k-space data (942) with the magnetic resonance imaging receive antenna by controlling the magnetic resonance imaging system with the pulse sequence commands; and
- reconstruct (1002) magnetic resonance imaging data (944) from the k-space data.

15. A method of using the medical system of claim 13, wherein the method comprises:
- acquiring (1000) the k-space data with the magnetic resonance imaging receive antenna by controlling the magnetic resonance imaging system with pulse sequence commands (940); and
- reconstructing (1002) magnetic resonance imaging data (944) from the k-space data.
